# EUROPÄISCHE PATENTSCHRIFT

(11) **EP 2 380 201 B1**
(45) Veröffentlichungstag und Bekanntmachung des Hinweises auf die Patenterteilung: **16.03.2016**
(21) Anmeldenummer: 09768077.1
(22) Anmeldetag: 11.12.2009
(51) Int. Cl.: H01L 29/16, H01L 29/737, H01L 29/76

(54) **UNIPOLARER HETERO-JUNCTION-SPERRSCHICHT-TRANSISTOR**
UNIPOLAR HETEROJUNCTION DEPLETION-LAYER TRANSISTOR
TRANSISTOR UNIPOLAIRE À COUCHE BARRIÈRE À HÉTÉROJONCTION

(30) Priorität: 22.12.2008 DE 102008055100
(43) Veröffentlichungstag der Anmeldung: 26.10.2011
(73) Patentinhaber: IHP GmbH-Innovations for High Performance Microelectronics / Leibniz-Institut für innovative Mikroelektronik, 15236 Frankfurt / Oder (DE)
(72) Erfinder: MEHR, Wolfgang, 15754 Friedersdorf (DE); LIPPERT, Gunther, 15236 Frankfurt(Oder) (DE)
(74) Vertreter: Eisenführ Speiser
(86) Internationale Anmeldenummer: PCT/EP2009/066958
(87) Internationale Veröffentlichungsnummer: WO 2010/072590

(56) Entgegenhaltungen:
- US-A1- 2008 246 023
- QIN ZHANG ET AL: "Graphene nanoribbon tunnel transistors" IEEE ELECTRON DEVICE LETTERS IEEE USA, Bd. 29, Nr. 12, 21. November 2008 (2008-11-21), Seiten 1344-1346, XP002568836 ISSN: 0741-3106
- LIANG GENGCHIAU ET AL: "Ballistic graphene nanoribbon metal-oxide-semiconductor field-effect transistors: A full real-space quantum transport simulation" JOURNAL OF APPLIED PHYSICS, AMERICAN INSTITUTE OF PHYSICS. NEW YORK, US, Bd. 102, Nr. 5, 11. September 2007 (2007-09-11), Seiten 54307-54307, XP012101675 ISSN: 0021-8979

## Beschreibung

Die Erfindung betrifft einen Unipolaren Heterojunction-Sperrschichttransistor (UHST).

Unipolare Heterojunction-Sperrschichttransistoren werden als Halbleiterbauelemente in Hochfrequenzschaltungen eingesetzt, wie beispielsweise in Schaltungen für Anwendungen in der Breitband- und der drahtlosen Kommunikation, oder in Radar- und Sensoranwendungen.

Es werden Transistoren benötigt, die mit Signalfrequenzen betrieben werden können, welche im Bereich von mehreren 100 GHz bis in den Bereich von einigen THz liegen. Bisherige, in der industriellen Produktion verwendete Transistorstrukturen für diesen hohen Frequenzbereich nutzen z. B. siliziumbasierte Hetero-Junction-Bipolar-Transistoren (HBT) mit einer aus einer Silizium-Germanium-Legierung gefertigten Basis.

Das Dokument US 2004/0232505 beschreibt eine Sperrschichttransistor-Struktur, die zwischen einer Emitterelektrode und einer Basiselektrode eine erste Mehrschicht-Tunnelstruktur aufweist, die einen Elektronentransport vom Emitter in die Basis durch resonantes Tunneln zulässt. Zwischen der Basis- und der Kollektorelektrode ist eine zweite Mehrschicht-Struktur vorgesehen, durch die die vom Emitter in die Basis gelangten Elektronen in den Kollektor gelangen können.

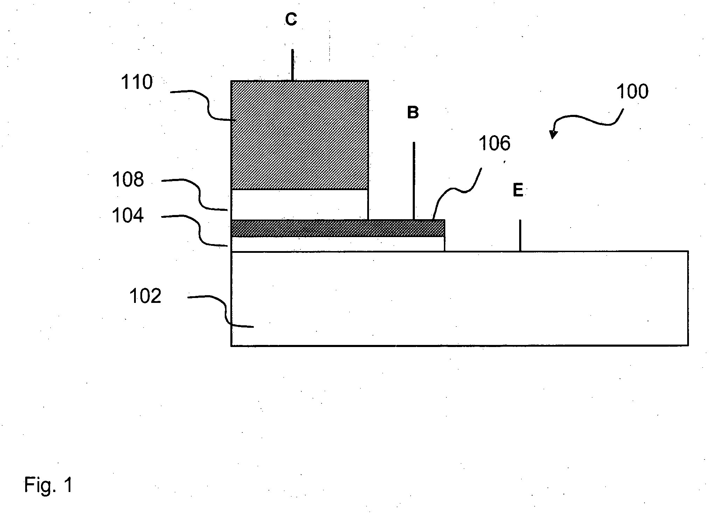

Das Dokument QIN ZHANG ET AL: "Graphene nanoribbon tunnel transistors" IEEE ELECTRON DEVICE LETTERS IEEE USA, Bd. 29, Nr. 12, 21 November 2008 (2008-11-21), Seiten 1344-1346, ISSN: 0741-3106 zeigt in Fig. 1 einen Tunneltransistor vom Feldeffekt-Typ. Bei diesem Transistor ist zwischen einem n⁺-Sourcegebiet und einem p⁺-Draingebiet ein ebenfalls p⁺-dotiertes Kanalgebiet vorgesehen, das bei verschwindender Gate-Spannung vollständig verarmt ist. Der Kanal besteht aus Graphen-Nano"bändern" (graphene nanoribbons, GNRs), die einen eindimensionalen Ladungsträgertransport in ihrer Längsrichtung ermöglichen. Solche GNRs werden dort als vorteilhaft beschrieben, um in einem Tunnel-Feldeffekttransistor den Tunnelstrom im ON-Zustand zu erhöhen.

Der vorliegenden Erfindung liegt das technische Problem zugrunde, eine verbesserte Sperrschicht-Transistorstruktur anzugeben, die für Betriebsfrequenzen bis in den Terahertzbereich geeignet ist.

Das technische Problem wird gelöst durch einen unipolaren Heterojunction-Sperrschichttransistor, mit einer Basis, einem Emitter und einem Kollektor, bei dem der Emitter eine Tunneldiode enthält, welche bei einer anliegenden Emitter-Basisspannung in Flussrichtung oberhalb einer ersten Schwellenspannung einen Tunnelstrom von Ladungsträgern vom Emitter in Richtung des Kollektors zulässt, und bei dem die Basis eine Graphenschicht enthält.

Die Erfindung beruht auf der Erkenntnis, dass eine dünne metallisch leitfähige Basisschicht als Elektrode den Emitter/Kollektorstrom steuern kann.

Als Graphen wird im Allgemeinen eine dünne Kohlenstoffschicht mit der Wabenstruktur des Graphits bezeichnet. Die Kohlenstoffatome einer Monolage Graphen befinden sich in einer quasiebenen, wabenförmige Anordnung. Graphen hat gegenüber Metall-Elementen die vorteilhafte Eigenschaft einer anisotropen Elektronenbeweglichkeit. Dadurch greift das Feld der Kollektorspannung in einer bevorzugten Richtung stärker als bei Metall durch die Graphen-Basis und begünstigt ein "Absaugen" der Elektronen in Richtung Kollektor.

Graphen kann mit einer besonders hohen Elektronenbeweglichkeit bis 200 000 cm²/Vs unter idealen Bedingungen hergestellt werden, wie an sich aus der Veröffentlichung Bolotin, K.I.: Ultrahigh electron mobility in suspended graphene, arXiv:0802.2389v1, 2008 bekannt ist. Der erfindungsgemäße UHST hat durch die Verwendung einer Graphenschicht einen besonders geringen Basiswiderstand.

Dies ermöglicht einen Betrieb unter besonders hohen Frequenzen und zugleich eine gegenüber bekannten Strukturen wesentlich erhöhte Ansteuergeschwindigkeit. In Wirkverbindung mit der geringen Verzögerungszeit des Tunnelprozesses der Emitter-/Basisdiode wird durch die Erfindung daher eine Transistorstruktur bereitgestellt, die stark verbesserte Hochfrequenzeigenschaften aufweist.

Die Steuerung des Transistors erfolgt über die Ansteuerung einer Tunneldiode, die in eine Richtung sperrt und in Gegenrichtung, der Flussrichtung, einen Tunnelstrom zulässt, der im wesentlichen zugleich den Emitter-Kollektorstrom bildet. Der Tunnelstrom in Flussrichtung kann in geeigneten Ausgestaltungen des erfindungsgemäßen Transistors mit Betriebsfrequenzen im THz-Bereich geschaltet werden.

Mit der erfindungsgemäßen Struktur gelingt es zusammenfassend, einen Sperrschichttransistor für besonders hohe Frequenzen herzustellen.

Nachfolgend werden Ausführungsbeispiele des erfindungsgemäßen Sperrschichttransistors erläutert. Die zusätzlichen Merkmale der Ausführungsbeispiele können miteinander zur Bildung weitere Ausführungsformen kombiniert werden, es sei denn, sie sind als Alternativen offenbart.

Die Graphenschicht des Sperrschichttransistors der vorliegenden Erfindung hat in unterschiedlichen Ausführungsbeispielen eine Dicke zwischen genau einer und einigen Atomlagen.

Bevorzugt weist die Basis keine weiteren Schichten als die Graphenschicht auf. Mit anderen Worten besteht die Basis in einem Ausführungsbeispiel aus der Graphenschicht.

Bei einem Ausführungsbeispiel bildet der Emitter zur Basis hin eine Mehrschichtstruktur. Die Mehrschichtstruktur enthält zwischen der Graphenschicht und dem Emitter eine Emitter-Barrierenschicht als Tunnelbarriere. Diese Emitter-Barrierenschicht ist ausgebildet, bei anliegenden Emitter-Basis-Spannungswerten unterhalb der ersten Schwellenspannung einen Ladungsträgertransport zwischen dem Emitter und der Graphenschicht zu blockieren und oberhalb der Schwellenspannung einen Tunnelstrom zwischen dem Emitter und der Graphenschicht durchzulassen. Mit dem Einsatz der Emitter-Barrierenschicht gelingt zugleich eine Beherrschung geschwindigkeitsbeeinflussender Grenzflächeneigenschaften zwischen Basis und Emitter.

Als Material der Ermitter-Barrierenschicht eignet sich insbesondere Siliziumdioxid (SiO₂), aber auch ein anderes Dielektrikum. Dieses Dielektrikum, einschließlich der Grenzfläche zur Emitter- und zur Basisschicht, sind vorzugsweise besonders defektarm.

Die Schichtdicke der Emitter-Barrierenschicht liegt in typischen Ausführungsbeispielen unter 2 nm.

Bei einem weiteren Ausführungsbeispiel ist zwischen der Graphenschicht und dem Kollektor eine Kollektor-Barrierenschicht angeordnet. Die Kollektor-Barrierenschicht kann als dielektrische Sperrschicht zwischen Basis und Kollektor ausgebindet sein. Die Kollektor-Barrierenschicht ist so ausgebildet, dass ohne Ladungsträgerinjektion aus dem Emitter kein Ladungsträgerstrom zwischen Basis und Kollektor fließen kann.

Die Dicke der Kollektor-Sperrschicht beträgt in einem Ausführungsbeispiel maximal etwa 8nm. Durch eine geeignete Wahl der Dicke wie auch der Dielektrizitätskonstante lässt sich sowohl die maximale Kollektorspannung als auch die Basis-Kollektor-Kapazität einstellen. Durch die Graphenschicht können über eine geeignete Ansteuerung der Tunneldiode Ladungsträger in das Leitungsband der Kollektor-Barrierenschicht hinein injiziert werden. Damit kann der Kollektorwiderstand gesteuert werden.

Die Kollektor-Barrierenschicht ist vorzugsweise aus einem Dielektrikum gefertigt, das beispielsweise SiO₂, jedoch auch ein dielektrisches Material sein kann, das eine andere Dielektrizitätskonstante als das Material der Emitter-Barrierenschicht haben kann. Die Kollektor-Barrierenschicht aus SiO₂ ist in einem Ausführungsbeispiel auf einer Silizium-Kollektorschicht bzw. auf Si-Einkristallsubstrat angeordnet.

In einem Ausführungsbeispiel ist die Emitter-Barrierenschicht aus einem ersten Dielektrikum und die Kollektor-Barrierenschicht aus einem zweiten Dielektrikum gefertigt, wobei eine Bandlücke zwischen Valenz- und Leitungsband beim zweiten Dielektrikum entweder gleich groß oder geringer ist als beim ersten Dielektrikum. Es kann für bestimmte Ausführungsformen sinnvoll sein, dass das Material der Kollektor-Barrierenschicht eine kleinere Bandlücke zwischen Valenz- und Leitungsband hat als das Material der Emitter-Barrierenschicht.

Das Vorsehen sowohl einer Emitter-Barrierenschicht als auch einer Kollektor-Barrierenschicht, also beider Barrierenschichten zugleich in der Sperrschichttransistor-Struktur, bildet eine vorteilhafte Ausführungsform, ist aber nicht in jedem Anwendungsfall notwendig für das Funktionieren des Transistors. Entweder die Emitter- oder die Kollektor-Barrierenschicht kann in alternativen Ausführungsbeispielen die einzige Barrierenschicht des Sperrschichttransistors bilden.

Bei geeignet gestalteter Grenzfläche zwischen Emitter und Basis kann hier ohne Abscheidung einer Emitter-Barrierenschicht eine Schottky-Diode erzeugt werden. Dadurch kann in diesem Fall die Emitter-Barrierenschicht entfallen.

Zwischen Basis und Kollektor kann als Sperrschicht alternativ auch ein pn-Übergang oder eine undotierte Halbleiterschicht vorgesehen sein.

Die Emitterschicht ist in manchen Ausführungsformen aus einem dotierten ersten Halbleitermaterial eines ersten Leitfähigkeitstyps gefertigt, und der Kollektor aus einem Metall oder einem dotierten zweiten Halbleitermaterial des ersten Leitfähigkeitstyps, dessen Bandlücke geringer ist als die des Emitters. Die Dotierung kann hier als Freiheitsgrad fungieren, um die Bandlücke und Ladungsträgerkonzentration auf den entsprechenden Transistor einzustellen. Auf diese Weise können besonders hohe Ladungsträgerbeweglichkeiten erzielt werden. So kann das erste Halbleitermaterial beispielsweise Silizium und das zweite Halbleitermaterial eine Silizium-Germanium-Legierung oder Germanium sein. Hohe Ladungsträgerbeweglichkeiten werden weiter gefördert, wenn mindestens eines der ersten und zweiten Halbleitermaterialien einkristallin ist.

Grundsätzlich sind aber auch polykristalline oder amorphe Halbleitermaterialien für Emitter und Kollektor verwendbar, ebenso wie halbleitende Metalloxide.

In einem weiteren vereinfachten Ausführungsbeispiel enthält die Schichtstruktur des Transistors einen metallisch leitfähigen Emitter, der insbesondere aus einem Metall gefertigt sein kann, daran angrenzend ein Tunneldiodedielektrikum, an das direkt die Graphenbasis anschließt, gefolgt von einem Dielektrikum, beispielsweise mit hoher Dielektrizitätskonstante (high-k dielectric), und dem daran anschließenden Kollektor, der wiederum metallisch leitfähig oder sogar aus einem Metall gefertigt ist.

Nachfolgend werden Ausführungsbeispiele des erfindungsgemäßen Sperrschichttransistors anhand der beiliegenden Figuren erläutert.

Es zeigen:
Figur 1 eine stark schematisierte Querschnittansicht eines Ausführungsbeispiels eines Sperrschichttransistors der vorliegenden Erfindung;
Figuren 2 und 3 Banddiagramme von Sperrschichttransistoren bei unterschiedlichen Spannungszuständen und Materialzusammensetzungen; und
Fig. 4 ein Ersatzschaltbild des Sperrschichttransistors aus Fig. 1.

Figur 1 zeigt eine stark schematisierte Querschnittansicht eines Ausführungsbeispiels eines Sperrschichttransistors 100 der vorliegenden Erfindung.

In einem Siliziumsubstrat, wie beispielsweise einem kommerziellen Siliziumwafer ist ein Emitter 102 ausgebildet. Der Emitter ist n-dotiert. Auf dem Emitter 102 ist eine EmitterBasis-Barriere (Emitter-Barrierenschicht) 104 aus SiO₂ abgeschieden, mit einer Dicke von einigen Monolagen. Bei Varianten der dargestellten Struktur ist die Emitter-Basis-Barriere 104 wie oben erläutert durch andere Formen einer Tunneldiode ersetzt, wie beispielsweise durch eine Schottky-Diode, die von einer geeignet prozessierten direkten Grenzfläche zwischen Emitter und Basis gebildet wird.

Im Beispiel der Figur 1 folgt der Emitter-Barrierenschicht 104 eine Graphenschicht 106, wiederum mit einer Dicke von nur einer oder nur wenigen Atomlagen. Auf der Graphenschicht ist eine Kollektor-Barrierenschicht 108 abgeschieden. Die Kollektor-Barrierenschicht ist entweder aus SiO₂ oder einem Dielektrikum mit geringerer Bandlücke als der der Emitter-Barrierenschicht gefertigt. Dieser folgt in Richtung der Schichtabscheidung der Kollektor 110. Der Kollektor ist im vorliegenden Ausführungsbeispiel aus n-dotiertem Silizium gefertigt.

Die drei funktionellen Schichten des Transistors sind mit einem Emitterkontakt E, einem Basiskontakt B und einem Kollektorkontakt K kontaktiert.

Bei geeigneter Schichtausbildung kann der Transistor auch revers, d.h. mit dem Substrat als Kollektor und dem Topkontakt als Emitter, beschaltet werden.

Einzelheiten der Kontaktierung sind in Fig. 1 der Einfachheit der graphischen Darstellung halber fortgelassen.

Bei anliegenden Emitter-Basis-Spannungswerten unterhalb der ersten Schwellenspannung blockiert die Emitter-Barrierenschicht einen Ladungsträgertransport zwischen dem Emitter und der Graphenschicht, und oberhalb der ersten Schwellenspannung lässt sie einen Tunnelstrom zwischen dem Emitter und der Graphenschicht durch. Oberhalb der Schwellenspannung kann ein Ladungsträgerstrom zwischen dem Emitter und dem Kollektor fließen. Bei anliegenden Emitter-Kollektor-Spannungswerten unterhalb einer zweiten Schwellenspannung, die größer oder gleich der ersten Schwellenspannung ist, blockiert die Kollektor-Barrierenschicht einen Ladungsträgertransport zwischen der Graphenschicht und dem Kollektor.

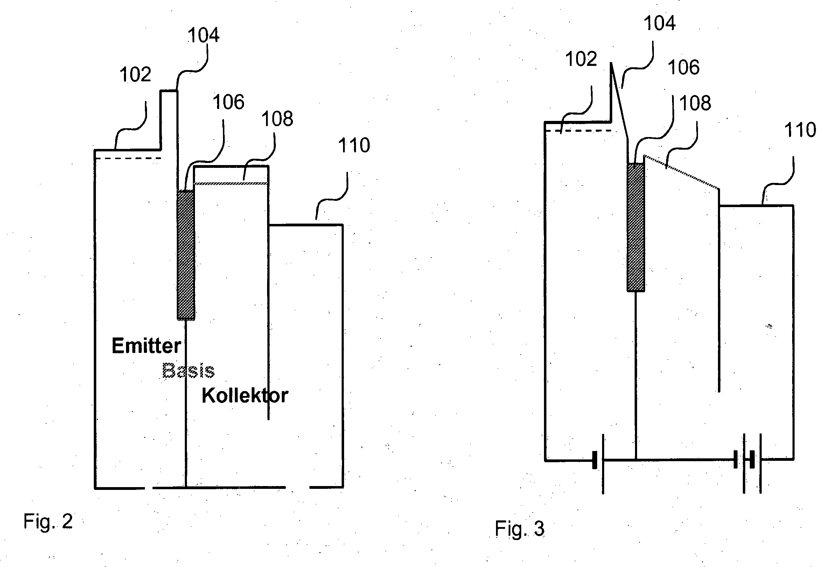

Fig. 2 zeigt ein schematisches Banddiagramm der Transistorstruktur 100 aus Fig. 1 in einem spannungslosen Zustand. Dargestellt ist in erste Linie die Leitungsbandkante der verschiedenen Schichten 102 bis 110 in einem spannungsfreien Zustand des Transistors. Erkennbar ist die Tuhnelbarriere der Emitter-Barrierenschicht 104. In der Emitterschicht eingezeichnete gestrichelte Linien kennzeichnen die Fermi-Energie. Für die Kollektor-Barrierenschicht 108 sind zwei alternative Leitungsbandunterkanten eingezeichnet. Mit der höheren Energie ist SiO₂ symbolisiert, mit der niedrigeren ein anderes Material wie beispielsweise ein Hoch-K Dielektrikum.

Fig. 3 zeigt ein mit der Fig. 2 zu vergleichendes Banddiagramm für den Fall einer anliegenden Betriebsspannung zwischen Emitter und Basis, die einen Tunnelstrom zulässt, und einer Emitter-Kollektorspannung, die einen Emitter-Kollektorstrom über die Kollektorbarriere 108 hinweg ermöglicht.

Mit der dargestellten Struktur gelingt es, Betriebsfrequenzen im THz-Bereich zu erzielen.

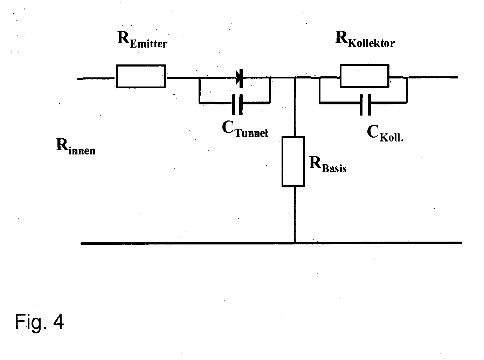

Fig. 4 zeigt ein Ersatzschaltbild des Sperrschichttransistors 100 der Fig. 1. Der Innenwiderstand Rᵢₙₙₑₙ des Transistors wird durch folgende Einflussgrößen geprägt:
- einem von der Defektdichte in der Emitterstruktur abhängigen Emitterwiderstand R_{Emitter}; dieser kann durch einkristalline, defektarme Ausbildung des Emitters gering gehalten werden;
- dem Sperrverhalten der Tunneldiode zwischen Emitter und Basis;
- einer parasitären Basis-Emitter-Kapazität C_{Tunnel} der Tunneldiode, die im Ersatzschaltbild zur Tunneldiode parallel geschaltet ist;
- einem von der Ausbildung der Kollektorbarriere abhängigen Kollektorwiderstarid und einer dazu parallel geschalteten parasitären Basis-Kollektorkapazität; letztere kann durch oben bereits erläuterte Maßnahmen gering gehalten werden; und
- dem Basiswiderstand R_{Basis}. Dieser ist aufgrund der geringen Schichtdicke und des verwendeten Basismaterials Graphen besonders gering.

## Patentansprüche

1. Unipolarer Heterojunction-Sperrschichttransistor (100), mit
- einer Basis (106), einem Emitter (102)) und einem Kollektor (110),
- der Emitter (102) eine Tunneldiode enthält, welche bei einer anliegenden Emitter-Basisspannung in Flussrichtung oberhalb einer ersten Schwellenspannung einen Tunnelstrom von Ladungsträgern vom Emitter in Richtung des Kollektors zulässt, und
**dadurch gekennzeichnet dass**
- die Basis eine Graphenschicht (106) enthält.

2. Sperrschichttransistor nach Anspruch 1, bei dem zwischen der Graphenschicht (106) und dem Emitter (102) eine Emitter-Barrierenschicht (104) angeordnet ist, die ausgebildet ist, bei anliegenden Emitter-Basis-Spannungswerten unterhalb der ersten Schwellenspannung einen Ladungsträgertransport zwischen dem Emitter und der Graphenschicht zu blockieren und oberhalb der Schwellenspannung den Tunnelstrom zwischen dem Emitter und der Graphenschicht durchzulassen.

3. Sperrschichttransistor nach Anspruch 1 oder 2, bei dem zwischen der Graphenschicht (106) und dem Kollektor (110) eine Kollektor-Barrierenschicht (108) angeordnet ist.

4. Sperrschichttransistor nach Anspruch 3, bei dem die Emitter-Barrierenschicht (104) aus einem ersten Dielektrikum und die Kollektor-Barrierenschicht (108) aus einem zweiten Dielektrikum gefertigt ist.

5. Sperrschichttransistor nach Anspruch 4, bei dem eine Bandlücke zwischen Valenz- und Leitungsband beim zweiten Dielektrikum gleich groß ist als die des ersten Dielektrikums.

6. Sperrschichttransistor nach Anspruch 4, bei dem eine Bandlücke zwischen Valenz- und Leitungsband des zweiten Dielektrikum sich von der des ersten Dielektrikums unterscheidet.

7. Sperrschichttransistor nach einem der Ansprüche 2 bis 6, bei dem die Emitter-Barrierenschicht (104) aus Siliziumoxid oder einem anderen Dielektrikum gefertigt ist.

8. Sperrschichttransistor nach Anspruch 7, bei dem die Emitter-Barrierenschicht (104) und/oder die Kollektor-Barrierenschicht (108) entweder polykristallin oder einkristallin ist.

9. Sperrschichttransistor nach Anspruch 8, bei dem die Emitter-Barrierenschicht (104) eine Schichtdicke von einigen Atomlagen hat.

10. Sperrschichttransistor nach Anspruch 1, bei dem eine Grenzfläche zwischen Emitter (102) und Basis (106) eine Schottky-Diode bildet, ohne dass zwischen Emitter und Basis eine Emitter-Barrierenschicht abgeschieden ist.

11. Sperrschichttransistor nach einem der vorstehenden Ansprüche, bei dem die Emitterschicht (102) entweder aus einem dotierten ersten Halbleitermaterial eines ersten Leitfähigkeitstyps oder aus einem Metall gefertigt ist, und bei dem der Kollektor (110) aus einem Metall oder einem dotierten zweiten Halbleitermaterial des ersten Leitfähigkeitstyps gefertigt ist.

12. Sperrschichttransistor nach Anspruch 11, bei dem das erste Halbleitermaterial Silizium und das zweite Halbleitermaterial eine Silizium-Germanium-Legierung oder Germanium ist.

13. Sperrschichttransistor nach Anspruch 11 oder 12, bei dem mindestens eines der ersten und zweiten Halbleitermaterialien einkristallin ist.

14. Sperrschichttransistor nach Anspruch 11 oder 12, bei dem mindestens eines der ersten und zweiten Halbleitermaterialien polykristallin oder amorph ist.

15. Sperrschichttransistor nach einem der vorstehenden Ansprüche, bei dem der Emitter (102) oder der Kollektor (110) oder sowohl der Emitter als auch der Kollektor aus einem Metalloxid gefertigt ist.

16. Sperrschichttransistor nach einem der vorstehenden Ansprüche, bei dem die Basis (106) aus der Graphenschicht besteht.

## Claims

1. Unipolar heterojunction depletion-layer transistor (100), having
- a base (106), an emitter (102) and a collector (110),
- the emitter (102) containing a tunnel diode which, when an emitter base voltage is applied in the direction of flow above a first threshold voltage, allows a tunnel flow of charge carriers from the emitter towards the collector, and
**characterised in that**
- the base contains a graphene layer (106).

2. Depletion-layer transistor according to claim 1, wherein between the graphene layer (106) and the emitter (102) an emitter barrier layer (104) is provided which is configured to block the transporting of charge carriers between the emitter and the graphene layer when emitter base voltage values are applied below the first threshold voltage and to allow the tunnel flow to pass through between the emitter and the graphene layer above the threshold voltage.

3. Depletion-layer transistor according to claim 1 or 2, wherein a collector barrier layer (108) is arranged between the graphene layer (106) and the collector (110).

4. Depletion-layer transistor according to claim 3, wherein the emitter barrier layer (104) is made from a first dielectric and the collector barrier layer (108) is made from a second dielectric.

5. Depletion-layer transistor according to claim 4, wherein a band gap between the valence band and conduction band in the second dielectric is the same size as that of the first dielectric.

6. Depletion-layer transistor according to claim 4, wherein a band gap between the valence band and conduction band in the second dielectric differs from that of the first dielectric.

7. Depletion-layer transistor according to one of claims 2 to 6, wherein the emitter barrier layer (104) is made from silicon oxide or another dielectric.

8. Depletion-layer transistor according to claim 7, wherein the emitter barrier layer (104) and/or the collector barrier layer (108) is or are either polycrystalline or monocrystalline.

9. Depletion-layer transistor according to claim 8, wherein the emitter barrier layer (104) has a layer thickness of a few atom layers.

10. Depletion-layer transistor according to claim 1, wherein an interface between the emitter (102) and the base (106) forms a Schottky diode without an emitter barrier layer being deposited between the emitter and the base.

11. Depletion-layer transistor according to one of the preceding claims, wherein the emitter layer (102) is made from either a doped first semiconductor material of a first conductivity type or from a metal, and wherein the collector (110) is made from a metal or from a doped second semiconductor material of the first conductivity type.

12. Depletion-layer transistor according to claim 11, wherein the first semiconductor material is silicon and the second semiconductor material is a silicon-germanium alloy or germanium.

13. Depletion-layer transistor according to claim 11 or 12, wherein at least one of the first and second semiconductor materials is monocrystalline.

14. Depletion-layer transistor according to claim 11 or 12, wherein at least one of the first and second semiconductor materials is polycrystalline or amorphous.

15. Depletion-layer transistor according to one of the preceding claims, wherein the emitter (102) or the collector (110) or both the emitter and the collector is or are made from a metal oxide.

16. Depletion-layer transistor according to one of the preceding claims, wherein the base (106) consists of the graphene layer.

## Revendications

1. Transistor unipolaire à couche barrière à hétérojonction (100), comprenant :
- une base (106), un émetteur (102) et un collecteur (110),
- l'émetteur (102) contenant une diode tunnel qui, lorsqu'une tension émetteur-base est appliquée dans le sens passant au-dessus d'une première tension de seuil, autorise un courant de tunnel depuis des porteurs de charge de l'émetteur dans la direction du collecteur,
**caractérisé en ce que**
- la base contient une couche de graphène (106).

2. Transistor à couche barrière selon la revendication 1, dans lequel il est agencé entre la couche de graphène (106) et l'émetteur (102) une couche de barrière de l'émetteur (104) qui est conçue de façon à bloquer un transport des porteurs de charge entre l'émetteur et la couche de graphène en dessous de la première tension de seuil et à laisser passer le courant de tunnel entre l'émetteur et la couche de graphène au-dessus de la tension de seuil en présence de valeurs de tension émetteur-base.

3. Transistor à couche barrière selon la revendication 1 ou 2, dans lequel il est agencé entre la couche de graphène (106) et le collecteur (110) une couche de barrière du collecteur (108).

4. Transistor à couche barrière selon la revendication 3, dans lequel la couche de barrière de l'émetteur (104) est réalisée à partir d'un premier diélectrique et la couche de barrière du collecteur (108) à partir d'un deuxième diélectrique.

5. Transistor à couche barrière selon la revendication 4, dans lequel une bande interdite entre la bande de valence et la bande de conduction du deuxième diélectrique a la même grandeur que celle du premier diélectrique.

6. Transistor à couche barrière selon la revendication 4, dans lequel une bande interdite entre la bande de valence et la bande de conduction du deuxième diélectrique est différente de celle du premier diélectrique.

7. Transistor à couche barrière selon l'une des revendications 2 à 6, dans lequel la couche de barrière de l'émetteur (104) est réalisée à partir d'oxyde de silicium ou d'un autre diélectrique.

8. Transistor à couche barrière selon la revendication 7, dans lequel la couche de barrière de l'émetteur (104) et/ou la couche de barrière du collecteur (108) est/sont soit polycristalline(s), soit monocristalline(s).

9. Transistor à couche barrière selon la revendication 8, dans lequel la couche de barrière de l'émetteur (104) a une épaisseur de couche de quelques couches atomiques.

10. Transistor à couche barrière selon la revendication 1, dans lequel une interface entre l'émetteur (102) et la base (106) forme une diode de Schottky sans qu'une couche de barrière de l'émetteur soit éliminée entre l'émetteur et la base.

11. Transistor à couche barrière selon l'une des revendications précédentes, dans lequel la couche de l'émetteur (102) est réalisée soit à partir d'un premier matériau semi-conducteur dopé d'un premier type de conductivité, soit à partir d'un métal et dans lequel le collecteur (110) est réalisé à partir d'un métal ou d'un deuxième matériau semi-conducteur dopé du premier type de conductivité.

12. Transistor à couche barrière selon la revendication 11, dans lequel le premier matériau semi-conducteur est le silicium et le deuxième matériau semi-conducteur est un alliage de silicium et de germanium ou le germanium.

13. Transistor à couche barrière selon la revendication 11 ou 12, dans lequel au moins l'un des premier et deuxième matériaux semi-conducteurs est monocristallin.

14. Transistor à couche barrière selon la revendication 11 ou 12, dans lequel au moins l'un des premier et deuxième matériaux semi-conducteurs est polycristallin ou amorphe.

15. Transistor à couche barrière selon l'une des revendications précédentes, dans lequel l'émetteur (102) ou le collecteur (110) ou à la fois l'émetteur et le collecteur sont réalisés à partir d'un oxyde métallique.

16. Transistor à couche barrière selon l'une des revendications précédentes, dans lequel la base (106) est constituée par la couche de graphène.
